# EUROPÄISCHE PATENTANMELDUNG

(11) **EP 0 534 187 A2**
(43) Veröffentlichungstag der Anmeldung: **31.03.1993**
(21) Anmeldenummer: 92115044.7
(22) Anmeldetag: 03.09.1992
(51) Int. Cl.: G06F 11/26

(54) **Prüfeinrichtung für integrierte Schaltkreise**

(30) Priorität: 26.09.1991 DE 4132072
(71) Anmelder: GRUNDIG E.M.V. Elektro-Mechanische Versuchsanstalt Max Grundig holländ. Stiftung & Co. KG., D-90762 Fürth (DE)
(72) Erfinder: Mahmud, Shabaz, GRUNDIG E.M.V., Max Grundig, W-8510 Fürth/Bay (DE)
(74) Vertreter: Eichstädt, Alfred

(57) **Zusammenfassung**

Die Erfindung betrifft eine integrierte Halbleiterschaltung, die aus einer Anzahl von Funktionsblöcken besteht, welche einzeln getestet werden können, und die eine Auswahlanordnung enthält, mit der die einzelnen Funktionsblöcke zum Test ausgewählt werden. Durch die Entwicklung zu immer höheren Integrationsdichten bei integrierten Schaltungen wird es immer schwieriger, eine Prüfung auf Funktionsfähigkeit durchzuführen. Aus diesem Grund muß bereits bei der Entwicklung einer integrierten Schaltung auf spätere Testbarkeit geachtet werden.

Deshalb wird in einer integrierten Halbleiterschaltung ein Nur-Lese-Speicher-Bereich (ROM-Bereich) vorgesehen, in dem jeweils unter einer Adresse ein Bitmuster abgelegt ist, das zur Ansteuerung einer Auswahlschaltung bzw. zur direkten Auswahl des zu testenden Funktionsblockes dient. Weiterhin ist ein Zähler vorgesehen, dessen Zählerstand durch ein externes Zählsignal erhäht werden kann, und dessen Zählerstand eine Adresse für den Nur-Lese-Speicher-Bereich angibt, die ein Bitmuster für die Auswahl eines Funktionsblockes enthält.

## Beschreibung

Die Erfindung betrifft eine integrierte Halbleiterschaltung, die aus einer Anzahl von Funktionsblöcken besteht, welche einzeln getestet werden können und die eine Auswahlanordnung enthält, mit der die einzelnen Funktionsblöcke zum Test ausgewählt werden.

Durch die Entwicklung zu immer höheren Integrationsdichten bei integrierten Schaltungen wird es immer schwieriger eine Prüfung auf Funktionsfähigkeit durchzuführen. Aus diesem Grund muß bereits bei der Entwicklung einer integrierten Schaltung auf spätere Testbarkeit geachtet werden.

Da bei den komplexen Schaltkreisen eine Prüfung der gesamten Schaltung auf Fehlfunktionen sehr schwierig oder sehr aufwendig wird, werden integrierte Schaltungen in eine Anzahl von Funktionsblöcken unterteilt, die einzeln geprüft werden können. Zur Prüfung der einzelnen Funktionsblöcke müssen ihre Funktionen einzeln nach außen sichtbar gemacht werden, d.h. sie müssen einzeln angewählt werden können.

Beim Anwählen der Funktionsblöcke durch Anwahlsignale, die jeweils durch einen Außenanschluß der integrierten Schaltung an einen Funktionsblock gelegt werden, steigt jedoch mit der Anzahl der vorhandenen Funktionsblöcke auch die Anzahl der Außenanschlüsse der integrierten Schaltung, was eine Vergrößerung des Gehäuses der integrierten Schaltung zur Folge hat.

In der deutschen Offenlegungsschrift DE-OS-3913219 wird eine integrierte Halbleiterschaltung beschrieben, die in einzelne Funktionsblöcke aufgeteilt ist. Jedem Funktionsblock wird ein Suchpfad zugeordnet. Dadurch bildet jeder Funktionsblock einen Testblock, dem die Testdaten seriell durch einen Testdatenanschluß am Gehäuse zugeführt werden und dem die Ausgangsdaten ebenfalls seriell über einen Anschluß am Gehäuse entnommen werden können.

Bei einer Anordnung gemäß dieser Offenlegungsschrift wird nicht mehr jeder Testblock mit einem Takt, d.h. mit einem Auswahlsignal von außen versorgt, sondern die integrierte Schaltung enthält ein Register, das aus einer Anzahl von Schieberegistern, entsprechend der Anzahl von Testblöcken, besteht. Im Testmodus wird in das erste Registerelement ein Auswahlsignal geschrieben, das einen ersten Testblock auswählt, indem das Auswahlsignal (eine logische Eins) an ein UND-Gatter geführt wird, an dessem zweiten Eingang das Taktsignal zum Aktivieren des Testblocks anliegt, das an den Ausgang des UND-Gatters und dann an den damit verbundenen Testblock geführt wird. Zwei Testsignale, die am Register anliegen, verschieben das Auswahlsignal an das nächste Registerelement und aktivieren somit den nächsten Testblock, usw.

Da bei solchen Anordnungen mit Suchpfaden der zusätzliche Schaltungsaufwand durch das Anlegen der Suchpfade groß ist, werden häufig die Testdaten parallel über die vorhandenen Eingangsanschlüsse an die Funktionsblöcke angelegt und die Testergebnisse an die vorhandenen Ausgangsanschlüsse ausgegeben. Die Anwahl des zu testenden Funktionsblockes bzw. das Stillegen der anderen Funktionsblöcke erfolgt in einer Auswahlschaltung, die in der Regel aus einer Multiplexlogik besteht, die in die integrierte Schaltung eingebunden ist. Der Aufwand an zusätzlichen Anschlüssen für die Ansteuerung des Multiplexers ist abhängig von der Zahl der Funktionsblöcke und deren Busbreite. So können mit n Anschlüssen 2ⁿ Funktionsblöcke angewählt werden. Bei komplexen integrierten Schaltungen, die in eine größere Anzahl von Funktionsblöcken unterteilt sind, ist auf diese Weise eine relativ große Anzahl an zusätzlichen Anschlüssen für den Testbetrieb nötig, so daß unter Umständen das Gehäusevolumen eines integrierten Schaltkreises durch die benötigte Zahl der Außenanschlüsse größer wird und somit die Kosten erhöht werden.

Es ist deshalb die Aufgabe der Erfindung eine Anordnung zur Auswahl der Funktionsblöcke im Testmodus anzugeben, bei der die Zahl der für den Testbetrieb benötigten Außenanschlüsse reduziert ist.

Diese Aufgabe wird gelöst, indem in einer integrierten Halbleiterschaltung ein Nur-Lese-Speicher-Bereich (ROM-Bereich) vorgesehen ist, in dem jeweils unter einer Adresse ein Bitmuster abgelegt ist, das zur Ansteuerung einer Auswahlschaltung bzw. zur direkten Auswahl des zu testenden Funktionsblockes dient. Weiterhin enthält die integrierte Halbleiterschaltung einen Zähler, dessen Zählerstand durch ein externes Zählsignal erhöht werden kann. Der Zählerstand des Zählers stellt dabei eine Adresse für den ROM-Bereich dar, unter der ein Bitmuster für die Auswahl eines Funktionsblockes abgelegt ist.
Mit der erfindungsgemäßen Anordnung wird die Anzahl der für den Testbetrieb benötigten Außenanschlüsse auf zwei reduziert. Der erste Anschluß dient zum Aktivieren des Testmodus, der zweite Anschluß ist für das Zählsignal vorgesehen.

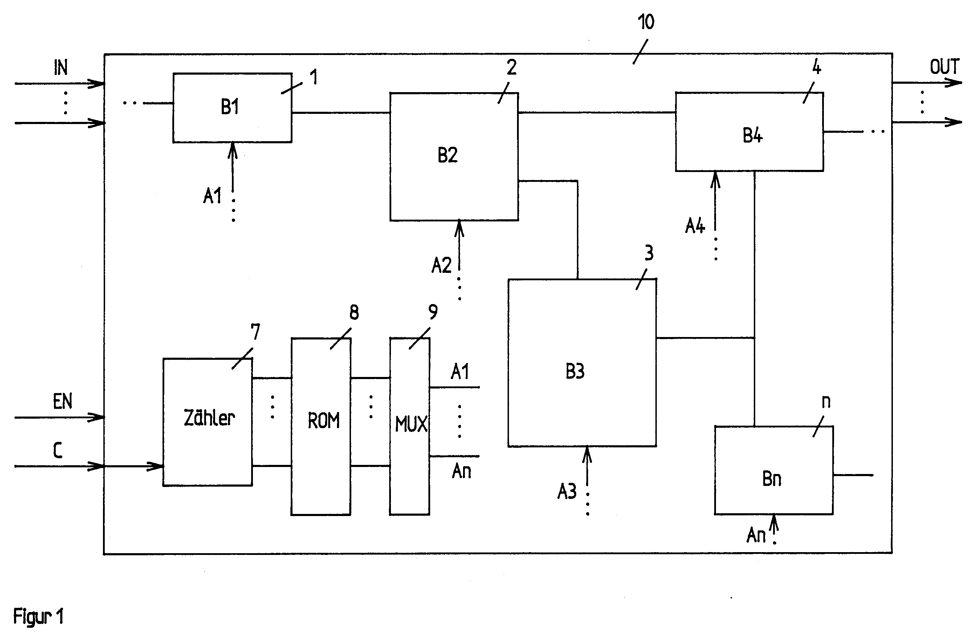

Im folgenden wird die Erfindung an Hand von Figur 1 beschrieben. Diese Figur zeigt eine integrierte Schaltungsanordnung 10 mit den Funktionsblöcken 1 bis n. Weiterhin enthält die Anordnung einen Zähler 7, dessen Zählerausgang mit einem Nur-Lese-Speicher 8 verbunden ist. Die Ausgänge des Speichers 8 sind mit den Eingängen des Multiplexers 9 verbunden. Die Ausgänge A1 bis An des Multiplexers 9 sind mit den Funktionsblöcken 1 bis n verbunden. Die integrierte Halbleiterschaltung enthält weiterhin Außenanschlüsse IN für Eingangsdaten und Außenanschlüsse OUT für den Datenausgang, sowie die für den Testmodus vorgesehenen Anschlüsse EN und C. Weitere Außenanschlüsse, wie Spannungsversorgung, Takt usw., die zum Verständnis der Erfindung unwesentlich sind, sind in Figur 1 nicht eingezeichnet.

Der Testbetrieb wird mit dem Test-Enable-Eingang EN aktiviert. Daten, die über die Eingänge IN an den integrierten Schaltkreis angelegt werden, werden im Testbetrieb beispielsweise über einen Datenbus den durch den Multiplexer 9 angewählten Funktionsblöcken zugeführt. Zur Testauswertung werden über die Ausgänge OUT die Testergebnisse verfügbar gemacht. Auf diese Weise kann die Funktionsfähigkeit jedes Funktionsblocks einzeln nach außen sichtbar gemacht werden, und Fehler werden leicht lokalisiert.

Das am Eingang C anliegende Zählsignal wird an den Zähler 7 geführt. Mit jedem Zählsignal wird der Zählerstand erhöht. Das Zählsignal kann von einem Testcomputer erzeugt und dem Zähler 7 zugeführt werden. Der Zählerstand des Zählers 7 ist die Adresse für den Nur-Lese-Speicher 8. Dieser Speicher hat mindestens n Speicherplätze, die durch n Adressen abgerufen werden können. In den Speicherplätzen sind jeweils die Auswahldaten enthalten, mit denen über den Multiplexer 9 die einzelnen Funktionsblöcke angesteuert werden.

Mit der erfindungsgemäßen Anordnung kann nacheinander jeder Funktionsblock getestet werden, ohne daß eine große Anzahl von Außenanschlüssen benötigt wird. Die Auswahlfunktion übernimmt der Speicher 8 in Abhängigkeit von dem Zählerstand des Zählers 7, also in Abhängigkeit von der ihm zugeführten Adresse.

Die Länge der Datenworte, die unter einer Adresse abgespeichert sind, ist abhängig von der Anzahl der Funktionsblöcke. Bei einer Datenwortlänge von n bit können über den Multiplexer 9 bis zu 2ⁿ Funktionsblöcke angesteuert werden.

In einer vorteilhaften Ausgestaltung der Erfindung wird für den Nicht-flüchtigen Speicherbereich 8 eine Datenwortlänge vorgesehen, die der Anzahl der Funktionsblöcke im integrierten Halbleiterschaltkreis entspricht. Auf diese Weise wird der Multiplexer 9 nicht mehr benötigt und die Funktionsblöcke werden direkt durch die Speicherausgänge aktiviert bzw. stillgelegt.

Bei einer weiteren Vergrößerung des Speicherbereiches ist es auch möglich, für einfache Funktionstests Testdaten im Speicher 8 abzulegen, so daß für einfache Tests keine Testdaten von außen zugeführt werden müssen.

## Patentansprüche

1. Anordnung zum Prüfen von integrierten Schaltkreisen (10), die intern in mehrere Funktionsblöcke (B1-Bn) aufgeteilt sind, von denen jeder Funktionsblock separat geprüft wird, indem mit einer Auswahlschaltung (9) jeder Funktionsblock angewählt wird, so daß ihm unabhängig von den anderen Funktionsblöcken Testsignale von außen zugeführt werden können, wobei die Testsignale über die vorhandenen Eingangsanschlüsse (IN) angelegt werden und die Testergebnisse über die vorhandenen Ausgangsanschlüsse (OUT) nach außen sichtbar gemacht werden, **dadurch gekennzeichnet,**
daß der integrierte Schaltkreis (10)
- einen Zähler (7) enthält, dessen Zählerstand jeweils durch einen extern zugeführten Zählimpuls (C) erhöht wird, und
- einen Speicherbereich (8) enthält, in dem unter verschiedenen Adressen Bitmuster abgelegt sind, die zur Ansteuerung einer Auswahlschaltung (9) dienen, und
- der Zählerstand des Zählers (7) dem Speicherbereich (8) als Adresse zugeführt wird.

2. Anordnung nach Anspruch 1, **dadurch gekennzeichnet**, daß die Halbleiterschaltung einen Signaleingang (EN) aufweist, der mit dem Zähler und mit der Auswahlschaltung verbunden ist, um den Prüfmodus zu aktivieren.

3. Anordnung nach Anspruch 1 oder 2, **dadurch gekennzeichnet**, daß der Speicherbereich (8) so ausgelegt ist, daß die unter den Adressen abgelegten Bitmuster zur direkten Auswahl der Funktionsblöcke herangezogen werden.

4. Anordnung nach einem oder mehreren der Ansprüche 1 bis 3, **dadurch gekennzeichnet**, daß der Speicherbereich (8) so ausgelegt ist, daß darin zusätzlich Testdaten abgelegt werden können.
